# EUROPEAN PATENT APPLICATION

(11) **EP 2 209 143 A1**
(43) Date of publication of application: **21.07.2010**
(21) Application number: 08840237.5
(22) Date of filing: 28.08.2008
(51) Int. Cl.: H01L 29/82, H01L 43/08, H03B 15/00

(54) **SPIN-VALVE ELEMENT**

(30) Priority: 15.10.2007 JP 2007267574
(71) Applicant: FUJI ELECTRIC HOLDINGS CO., LTD.;, Kanagawa 210-0856 (JP)
(72) Inventor:
(74) Representative: Appelt, Christian W.
(86) International application number: PCT/JP2008/065406
(87) International publication number: WO 2009/050945

(57) **Abstract**

In order to increase the power which can be passed to a spin valve element, an insulating layer 24 or a nonmagnetic layer 51 is sandwiched by ferromagnetic layers 23, 25, and a porous layer 10(10') having a plurality of minute holes is placed so as to be in contact with one of the ferromagnetic layers, or near the ferromagnetic layer with another layer intervening. By this means, even when a single-domain magnetic multilayer film extending over a broad region is not used, when, for example, microwave oscillation is induced by means of the spin valve element, the microwave power can be increased.

## Description

### TECHNICAL FIELD

This invention relates to a spin valve element. More specifically, this invention relates to a spin valve element which applies the tunneling magneto-resistance (TMR) effect or the giant magneto-resistance (GMR) effect.

### BACKGROUND ART

With recent advances in nanoelectronics, products are being developed which apply physical phenomena unique to magnetic materials with minute sizes. Of these, there have been particularly rapid advances in the field of spin electronics, which utilize the spin of free electrons in magnetic materials.

In the field of spin electronics, spin valve elements utilizing the tunneling magneto-resistance (TMR) effect occurring in a layered structure of a ferromagnetic layer, an insulating layer, and a ferromagnetic layer in order, or utilizing the giant magneto-resistance (GMR) effect occurring in a layered structure of a ferromagnetic layer, nonmagnetic layer (conducting layer), and a ferromagnetic layer in order, are currently regarded as having the greatest possibility of application.

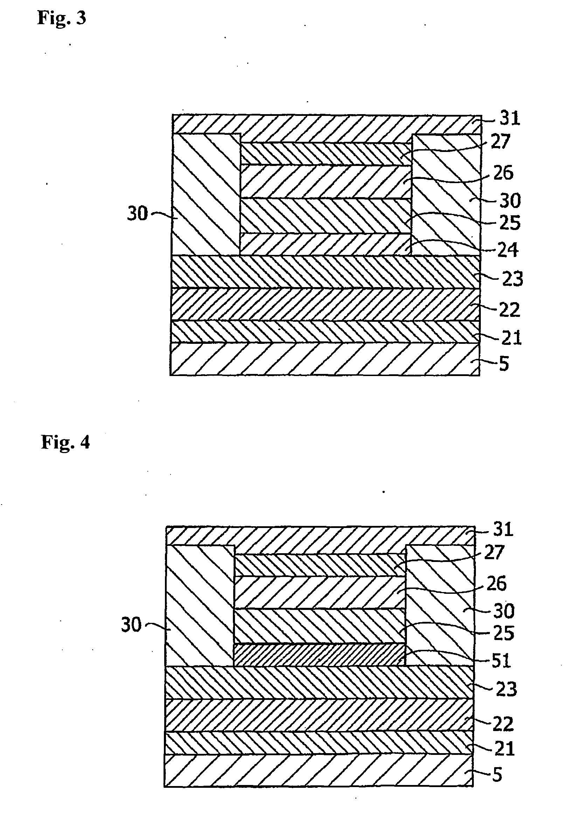

Fig. 3 and Fig. 4 are cross-sectional views showing the configuration of spin valve elements of the prior art. Of these, Fig. 3 shows the basic constituent portions of a spin valve element utilizing TMR. This spin valve element has a configuration in which single insulating layer 24 and ferromagnetic layers 23 (fixed layer) and 25 (free layer) sandwiching the insulating layer are formed on a substrate 5; to this are further added, as necessary, electrode layers 21, 27, an antiferromagnetic layer (pinning layer) 22, a capping layer 26, and similar. The direction of the magnetization of the fixed layer 23 is fixed by magnetic coupling with the antiferromagnetic layer 22 and similar. When electrons are passed from the fixed layer 23 toward the free layer 25 in this element, a torque acts to cause the spin of the free layer 25 to be aligned parallel to the direction of the magnetization of the fixed layer 23. And conversely, when electrons are passed from the free layer 25 toward the fixed layer 23, a torque acts on the spin of the free layer 25 so as to be antiparallel to the direction of the magnetization of the fixed layer 23. Through these actions, the direction of magnetization of the free layer 25 can be controlled by the direction of current in the free layer 25 (spin transfer magnetization reversal). In order to suppress the exchange coupling due to the leakage magnetic field from the film edge portions of the ferromagnetic layers 23 (fixed layer) and 25 (free layer) surrounding the insulating layer 24, the portion on the upper side of the insulating layer 24 is generally formed to be sufficiently smaller than on the substrate side, and an insulating film 30 is generally formed on the periphery. A number of methods may be used to form these structures; for example, after forming the layered film from the substrate up to the electrode 27, a negative resist is applied and photolithography is used for exposure, after which ion milling is performed to expose the upper portion of the insulating layer 24, after which an insulating layer 30 is formed by covering with SiO₂ or other means, followed by lift-off and formation of wiring 31. For reasons explained below, in conventional structures the size in in-plane directions must be made very small (≤ 150 nm), so that electron beam exposure or other expensive equipment is used.

Fig. 4 shows the basic constituent components of a spin valve element utilizing GMR. A difference with the element utilizing TMR in Fig. 3 is that the insulating layer 24 is replaced with a nonmagnetic layer 51; otherwise the functions are basically the same.

Among applications of these technologies, magnetic random access memory (MRAM) is attracting the greatest attention, and is anticipated as a replacement for conventional DRAM (Dynamic Random Access Memory) and SDRAM (Synchronous DRAM).

Further, it is known that if a current and an external magnetic field are simultaneously applied to these spin valve elements, microwave oscillation occurs (see for example Non-patent Reference 1). As an example, with respect to current direction, suppose that a current is passed such that the torque acts on the spin of the free layer 25 so as to become antiparallel to the direction of the magnetization of the fixed layer 23, and with respect to an external magnetic field, suppose that a torque acts on the spin of the free layer 25 so as to become parallel to the direction of the magnetization of the fixed layer 23. In this case, under conditions in which the two torques are counterbalanced, high-frequency oscillation in the microwave region can be induced.

In addition, it has been reported that when two elements are formed adjacently and when currents and external magnetic fields appropriate to these are applied, the oscillation frequencies and phases of the two become coincident, the frequency width is decreased, and microwave output at this time is also increased (see for example Non-patent Reference 2). This phenomenon is called a phase locking phenomenon, and the mechanism, though not yet be clarified, is inferred to arise from interaction between the high-frequency magnetic fields occurring in each of the elements; this phenomenon is attracting attention as means of increased output.

As technology to form patterns as magnetic recording media in hard disk devices and raise recording densities, for example Patent Reference 1 discloses the use of metal nano-pillars. And, in Non-patent Reference 3, control of the porous hole size, pitch, and depth when fabricating a porous alumina film from an aluminum film through manipulation of external conditions is disclosed. Also, in Non-patent Reference 4, development aimed at applications to so-called bit patterned media of hard disks is described.
Patent Reference 1: Japanese Patent Application Laid-open No. 2006-75942
Non-patent Reference 1: S.I. Kiselev et al, "Microwave oscillations of a nanomagnet driven by a spin-polarized current", Nature, Vol. 425, p. 380 (2003)
Non-patent Reference 2: S. Kaka et al, "Mutual phase-locking of microwave spin torque nano-oscillators", Nature, Vol. 437, p. 389 (2005)
Non-patent Reference 3: H. Masuda, "High-regularity metal nano-hole array based on anodic oxidized alumina", Kotai Butsuri (solid state physics), Vol. 31, No. 5, p. 493, 1996
Non-patent Reference 4: X.M. Yang et al, "Nanoscopic templates using self-assembled cylindrical diblock co-polymers for patterned media", J. Vac. Sci. Technol. B, Vol. 22, p. 3331 (2004)

However, the oscillation output of the above microwave oscillator element is no greater than approximately 0.16 µW for TMR and at approximately 10 pW for GMR, which are very low levels for practical application. The simplest means to increase output is to increate the element area, but this is difficult for the following reason. That is, in spin valve elements, in order to facilitate coherent rotation of spins necessary for spin-transfer magnetization inversion, the magnetic films must comprise a single magnetic domain. For example, in order to obtain a single magnetic domain in the magnetic film the periphery of which is circumscribed on the left and right by the insulating film 30 in Fig. 3 and Fig. 4, the size circumscribed by the insulating film 30 on the left and right must be made small. In this way, the size of the element is required to be at most a size in which domain walls do not exist; although varying with material and shape, this size is approximately 150 nm. The size of a single conventional spin valve element cannot be made larger than this dimension.

Because there is an upper limit to the size of one spin valve element, in order to obtain a large output, numerous minute elements must be integrated. As means of integration, photolithography techniques are most widely used and have high precision; but in order to fabricate magnetic members with microminiature sizes (≤ 150 nm), investment in electron beam exposure and similar expensive equipment is necessary, so that there is the problem of high manufacturing costs.

### DISCLOSURE OF THE INVENTION

This invention was devised in light of the above circumstances, and has as an object the provision at low cost of a high-output microwave oscillation element in which numerous spin valve elements are integrated.

In one mode of the invention, a magnetic element is provided, comprising a magnetic multilayer film, including at least three layers of an insulating layer and first and second ferromagnetic layers sandwiching the insulating layer, and a porous layer, placed in contact with the first ferromagnetic layer or near the first ferromagnetic layer with another layer intervening and having a plurality of minute holes, an electrical connection is made with the first ferromagnetic layer of the magnetic multilayer film through the minute holes of the porous layer, and another electrical connection is made with the second ferromagnetic layer.

And in another mode of the invention, a magnetic element is provided, comprising a magnetic multilayer film, including at least three layers of a nonmagnetic layer and first and second ferromagnetic layers sandwiching the nonmagnetic layer, and a porous layer, placed in contact with the first ferromagnetic layer or near the first ferromagnetic layer with another layer intervening and having a plurality of minute holes, an electrical connection is made with the first ferromagnetic layer of the magnetic multilayer film through the minute holes of the porous layer, and another electrical connection is made with the second ferromagnetic layer.

Further, in this invention the porous layer can be a porous alumina layer manufactured by anodic oxidation. And, in this invention, the distance between centers of adjacent minute holes in the porous layer can be made 1000 nm or less, or, the diameters (equivalent diameters) of the minute holes of the porous layer can be made 100 nm or less. In addition, in this invention, the porous layer can be formed using a nanoimprinting method.

By means of this invention, numerous spin valve elements can be integrated. As a result, for example, a large output microwave oscillation element can be provided at low cost.

### BRIEF DESCRIPTION OF THE DRAWINGS

Fig. 1 is a vertical cross-sectional view of the spin valve element of a first embodiment of the invention;
Fig. 2 is a horizontal cross-sectional view (cross-section A-A' in Fig. 1) of the spin valve element of the first embodiment of the invention;
Fig. 3 is a vertical cross-sectional view showing principal constituent portions of a conventional spin valve element utilizing TMR;
Fig. 4 is a vertical cross-sectional view showing principal constituent portions of a conventional spin valve element utilizing GMR;
Fig. 5 is a vertical cross-sectional view of the spin valve element of a second embodiment of the invention; and
Fig. 6 is a vertical cross-sectional view of the spin valve element of a third embodiment of the invention.

### EXPLANATION OF REFERENCE NUMERALS

- 5: Substrate
- 10: Porous alumina layer
- 10': Porous polymer layer
- 11: Electrode layer
- 110: Electrode layer
- 12: Minute hole
- 13: Electrode having heat resistance
- 21: Electrode layer
- 22: Antiferromagnetic layer (pinning layer)
- 23: Ferromagnetic layer (fixed layer)
- 24: Insulating layer
- 25: Ferromagnetic layer (free layer)
- 26: Capping layer
- 27: Electrode layer
- 30: Insulating layer
- 31: Wiring
- 40: Minute hole interval
- 41: Minute hole diameter
- 51: Nonmagnetic layer

### BEST MODE FOR CARRYING OUT THE INVENTION

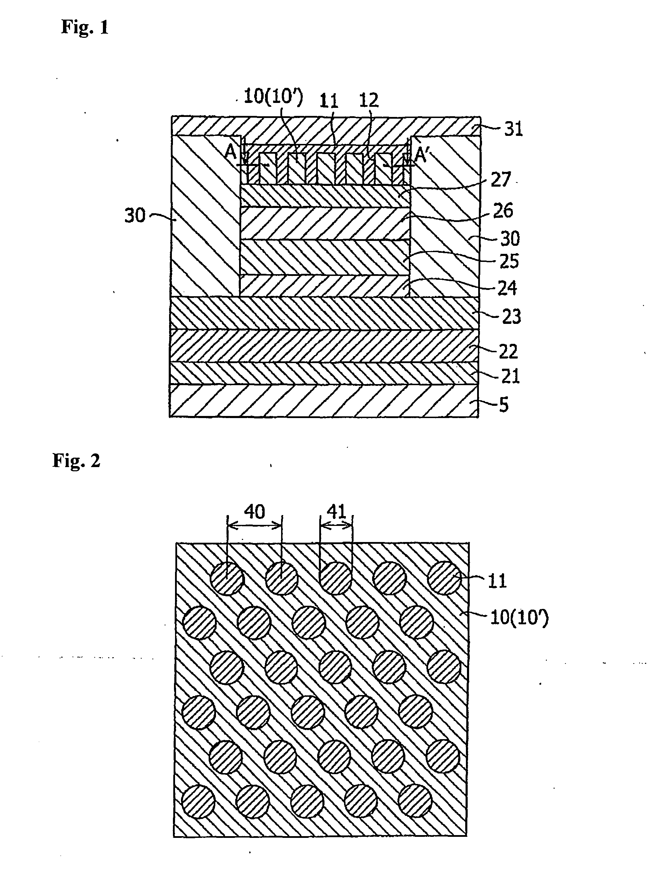

Below, embodiments of the invention are explained referring to the drawings. Fig. 1 and Fig. 2 show the basic configuration of a first embodiment of a spin valve element of the invention, and are respectively a vertical cross-sectional view, sectioned in a plane perpendicular to the substrate, and a horizontal cross-sectional view, sectioned in a parallel plane.

### First Embodiment

The spin valve element of the first embodiment comprises, on a substrate 5, a TMR layer, in which are layered in order an electrode layer 21, an antiferromagnetic layer (pinning layer) 22, a ferromagnetic layer 23 (fixed layer), an insulating layer 24, a ferromagnetic layer 25 (free layer), a capping layer 26, and an electrode layer 27; on this are formed a porous alumina layer 10, having a plurality of minute holes 12 and manufactured for example by anodic oxidation, and an electrode layer 11 formed on the porous alumina layer 10 and within the minute holes 12.

As examples of materials comprised by a spin valve element utilizing TMR, silicon substrate or glass substrate can be used as the substrate 5; tantalum (Ta), platinum (Pt), copper (Cu), or gold (Au) can be used as the electrode layers 21, 27, 11; IrMn or PtMn can be used as the antiferromagnetic layer 22; Co, CoFe, or CoFeB can be used as the ferromagnetic layer 23 (fixed layer); Al₂O₃ or MgO can be used as the insulating layer 24; Co, CoFe, CoFeB, or NiFe can be used as the ferromagnetic layer 25 (free layer); and Cu or Pd can be used as the capping layer 26. However, the materials of the substrate and layers are not limited to these, after layering of the layers, it is effective to perform magnetic field annealing in order to adjust the crystallinity of each layer and the magnetic anisotropy of the fixed layer. And, the ferromagnetic layer 23 (fixed layer) and ferromagnetic layer 25 (free layer) can be an antiferromagnetic coupled film of for example CoFeB/Ru/CoFeB or similar as necessary. Here, notation in which materials are delimited by a slash (/) indicates a layered member in which films of the materials are layered in that order.

Technology to perform anodic oxidation of an aluminum film and obtain a porous alumina layer is already used industrially; however, technology to manufacture the nanometer-order minute holes required in this invention has still been in the stage of development as technology for formation of recording dots for hard disks in recent years, and is not used commercialized. In this technology, in essence the size, pitch, and depth of the porous holes are controlled through manipulation of external conditions (see for example Non-patent Reference 3). By means of this method, nanometer-order minute holes can be formed which are densely packed in two dimensions, as shown in Fig. 2. In particular, porous alumina layers have high heat resistance, and so are sufficiently durable with respect to the annealing processes required for spin valve structures as described below, making them preferable from the standpoint of manufacturing processes.

The intervals between minute hoes in the porous layer can be chosen arbitrarily, but in order to obtain an effect of increased output through phase locking between spin valves, it is desirable that the intervals be 1000 nm or less, and still more desirable that the intervals be 500 nm or less. Further, it is desirable that the diameters (equivalent diameters) of the minute holes of the porous layer, which are the sizes of the minute holes, be 100 nm or less, and still more desirable that the diameters be 50 nm or less. The theoretical foundation for these numerical values is not yet clear, but the inventors of this application surmise that the intervals between minute holes are related to the distance of interaction between spin valve elements, and that the diameters of minute holes are related to the ease of formation of single domains in individual spin valve elements. Further, it is desirable that the depth of minute holes in the porous layer be three times or less than the diameter. This is in order to secure film deposition properties in the deep portions of holes when using vacuum deposition or other film deposition methods with comparatively high directionality to form the electrode layer 11 in particular.

The above-described equivalent diameter is the length which is equivalent to the diameter of a circle used to approximate a certain shape, and is used for the purpose of comparing the sizes of shapes. The equivalent diameter may include the projected area equivalent diameter, projected perimeter equivalent diameter, circumscribed circle and inscribed circle equivalent diameter, and similar. When a plurality of different equivalent diameters are obtained for a certain shape, the smallest among these is selected as the equivalent diameter of the minute holes in a preferred mode of the invention. In Fig. 1, Fig. 5 and Fig. 6, the antiferromagnetic layer 22 is explicitly shown; but the film thickness of the fixed layer may be made larger than that of the free layer without using this, and the coercive force of the fixed layer may be made larger than that of the free layer, to implement a spin valve element of this embodiment.

As the method of manufacturing the porous alumina layer 10, first an aluminum film is formed by sputtering or another method. As necessary, heat treatment can be performed in an inert gas or in vacuum at 400 to 500°C to coarsen the crystal grains and decrease crystal grain boundaries, so that a highly ordered arrangement of minute holes in the porous alumina layer can be obtained. Thereafter, an aqueous solution of H₃PO₄ or H₂SO₄ (phosphoric acid, sulfuric acid), or similar, is used to perform electrolytic polishing, to flatten the surface. Anodic oxidation treatment is performed. In this treatment, for example oxalic acid is used as the electrolytic solution (formation liquid), and by using a constant voltage of approximately 30 to 60 V as the formation voltage, minute holes are formed, regularly arranged and with high density. The regularity of arrangement of these minute holes advances with the passage of time in the anodic oxidation treatment, so that by performing anodic oxidation treatment over a long period of time, highly regular, densely arranged minute holes can be formed.

The intervals between minute holes formed by anodic oxidation treatment can be controlled through the applied voltage, and the interval per unit voltage is approximately 2.8 nm/V. That is, when the formation voltage is 40 V, the intervals are approximately 112 nm. The ratio of intervals to diameters of minute holes depends on the electrolytic solution and the treatment temperature, but can be adjusted within the range of approximately 1.5 to 5. The diameter per unit voltage when using oxalic acid as the electrolytic solution is approximately 4.9 nm/V, so that when formation voltage 40 V is applied, the diameter is approximately 23 nm.

In a porous alumina layer 10 obtained as described above, numerous minute holes are formed in a regular arrangement, and the holes are formed perpendicularly to the surface of the porous alumina layer 10. In this stage, the bottom portions of the holes are closed, and the holes are cylindrical spaces. In order to penetrate these holes as shown in Fig. 1, after anodic oxidation treatment, immersion treatment in H₃PO₄ or similar must be performed. Then, electroplating or another method is used to fill the interiors of the plurality of minute holes 12 of the porous alumina layer 10 with a metal material to form the electrodes 11.

### Second Embodiment

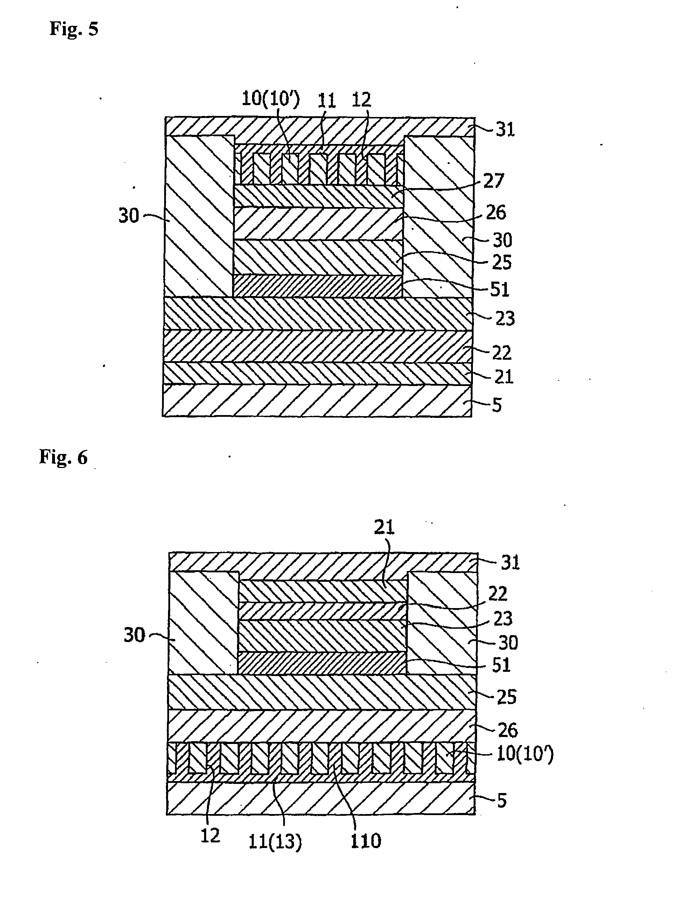

The structure of the spin valve element utilizing GMR of the second embodiment is shown in Fig. 5. The spin valve element of the second embodiment is configured similarly to the first embodiment, except for the fact that a nonmagnetic layer 51 is used in place of the insulating layer 24, and is similar to the first embodiment except for the fact that GMR, which is the giant magnetoresistance effect, is exhibited.

### Third Embodiment

The structure of the spin valve element of the third embodiment is shown in Fig. 6. In this embodiment, after first forming an electrode 11 and a porous alumina layer 10 on the substrate 5, the GMR element structure is manufactured thereupon. That is, in the spin valve element of the third embodiment, after forming the electrode 11 on the substrate 5, electroplating or another method is used to fill the interiors of the plurality of minute holes 12 of the porous alumina layer 10 with the electrode 110, and after flattening the surface by chemical-mechanical polishing or similar as necessary, a GMR layer similar to that of the second embodiment is formed, upside-down. In Fig. 6, the structure is shown with the electrode 27 omitted. Also, in Fig. 1, Fig. 5 and Fig. 6, the antiferromagnetic layer 22 is shown, but this is not used, and even when the film thickness of the fixed layer is made larger than that of the free layer and the coercivity of the fixed layer is made higher than that of the free layer, the spin valve element of this embodiment can be implemented.

In the above first through third embodiments, porous alumina manufactured by an anodic oxidation method is used, and by forming electrodes in the minute holes, numerous spin valve elements can easily be integrated.

Next, fourth through seventh embodiments of the invention, which use a porous polymer layer as the porous layer, are explained. Drawings used in the explanations are Fig. 1, Fig. 2, Fig. 5 and Fig. 6, used in explaining the above-described first through third embodiments.

### Fourth Embodiment

Fig. 1 and Fig. 2 show the structure of spin valve elements of the fourth embodiment. In this embodiment, a porous polymer layer 10 having a plurality of minute holes 12, and an electrode layer 11 formed on the porous polymer layer 10 and within the minute holes 12, are formed on a TMR layer, in which are layered in order, on a substrate 5, an electrode layer 21, antiferromagnetic layer (pinning layer) 22, ferromagnetic layer 23 (fixed layer), insulating layer 24, ferromagnetic layer 25 (free layer), capping layer 26, and electrode layer 27.

Materials comprised by the spin valve element using TMR are similar to those indicated in the first embodiment. Additionally, aluminum can be used as the electrodes 21, 26, 11.

Technology for forming a porous polymer layer utilizing resin self-organization has been developed in recent years, aiming at applications to so-called bit patterned media in hard disks (see for example Non-patent Reference 4). In this technology, in essence a solution of at least two types of non-miscible polymers is applied onto a substrate, and after heat treatment to induce phase separation of the polymers, one of the polymers is removed by chemical means to obtain a minute hole structure. Normally, this method can be used to obtain minute holes several tens of nanometers in diameter, at a pitch of several tens of nanometers.

In the fourth embodiment, similarly to the first embodiment, the interval between minute holes in the porous layer can be selected. At this time, in order to obtain an effect of increased output through phase locking between spin valves, it is desirable that the intervals (distances between centers of adjacent minute holes) be 1000 nm or less, and still more desirable that the intervals be 500 nm or less. Further, it is desirable that the diameters (equivalent diameters) of the minute holes of the porous layer be 100 nm or less, and still more desirable that the diameters be 50 nm or less, in order to obtain an effect of increased output due to phase locking. In the phase rocking phenomenon of the fourth embodiment, the theoretical foundation for the desirability of these numerical values is not yet clear, but the inventors of this application surmise that the intervals between minute holes are related to the distance of interaction between spin valve elements, and that the diameters of minute holes are related to the ease of formation of single domains in individual spin valve elements.

In the fourth embodiment, similarly to the first embodiment, it is preferable that the depths of the minute holes in the porous layer be three times or less than the diameters.

To explain the method of manufacturing a porous polymer layer 10' utilizing resin self-organization, for example a polystyrene-methyl methacrylate (PS-PMMA) copolymer is dissolved in toluene or another solvent, and this is applied onto a substrate by spin-coating or another method. Here, copolymer components of approximately PS:PMMA = 70:30 are appropriate for obtaining a porous structure. The spin-coating conditions and solvent concentration can be adjusted as appropriate depending on the film thickness of the porous polymer layer 10' which is desired; for example, to obtain a thickness of 40 to 50 nm, a spin-coating revolution rate of 1800 to 2400 rpm and a solid component concentration of 1 to 3 weight percent are desirable. Then, upon annealing in vacuum for several hours at 170°C, the polystyrene (PS) and polymethyl methacrylate (PMMA) undergo phase separation. One of the polymers (in the above material, PMMA) is selectively removed, to obtain a porous structure. In the case of the above composition, after irradiation with ultraviolet light to degrade the PMMA, washing with glacial acetic acid and water is performed to remove the PMMA, so that holes of diameter 20 nm at a pitch of approximately 40 nm can be obtained.

In order to form minute holes with a high aspect ratio perpendicularly to the substrate, the substrate may be treated with a self-organizing film or similar in advance, to adjust the surface energy of the substrate. Then, the interiors of the plurality of minute holes 12 of the porous polymer layer 10' are filled with a metal material by electroplating or another method, to form the electrode 11. Or, after forming the porous polymer layer 10' by the above method, the minute hole interiors are filled with a metal material, and then the remaining polymer is removed to form minute metal column structures, and after covering this with SiO₂ or another inorganic insulating material, the surface is polished and the metal exposed, enabling use as electrodes 13 having heat resistance. As the polymers used in this method, polystyrene (PS), polymethyl methacrylate (PMMA), polyisoprene, polylactide, and similar are used, but polymers which may be used are not limited to these.

The intervals between minute holes formed by the above method can be controlled primarily through the copolymer component ratio. The diameters of the minute holes are determined by the surface energy ratio of the polymer materials at the time of phase separation, and can be controlled through the copolymer materials, the solvent, the annealing temperature, and similar.

### Fifth Embodiment

The spin valve element of the fifth embodiment appears in Fig. 5. The spin valve element of the fifth embodiment has a configuration similar to that of the first embodiment, except for the fact that a nonmagnetic layer 51 is used in place of the insulating layer 24, and is similar to the fourth embodiment except for utilizing GMR, which is the giant magnetoresistance effect.

### Sixth Embodiment

The spin valve element of the sixth embodiment appears in Fig. 6. In this embodiment, after first forming an electrode 13 having heat resistance on a substrate, the GMR element structure is manufactured thereupon. That is, in the spin valve element of the sixth embodiment, after forming an electrode 11 on the substrate 5, the porous polymer layer 10' is formed thereupon. Then, electroplating or another method is used to fill the interiors of the plurality of minute holes 12 in the porous polymer layer 10' with electrodes 110, and then, by removing the remaining polymer, minute metal column structures are formed, and after covering this with SiO₂ or another inorganic insulating material, the surface is polished by chemical polishing or another means to expose the metal and form electrodes 13 having heat resistance. On this is formed a GMR layer similar to that of the fifth embodiment, but upside-down. In Fig. 6, a structure is shown in which the electrode 27 is omitted. In this way, by using a porous polymer layer 10' which utilizes resin self-organization to form electrodes in the minute holes, spin valve elements can easily be integrated.

In the above fourth through sixth embodiments, a porous polymer layer manufactured using resin self-organization was used, but minute holes can similarly be obtained by the nanoimprinting method described below.

In a nanoimprinting method, a stamper having a pattern of protrusion structures of size several tens to several hundreds of nanometers, machined using an electron beam or similar, is pressed against a resin thin film formed on a substrate and then drawn back, to transfer a relief structure pattern. Further, the depressed portions of the resin thin film are removed by reactive ion etching or similar, and the resin layer can be used as a mask to etch the substrate, to form a nanometer-size structure having a relief pattern corresponding to that of the original stamper. Control of the minute hole diameters is possible by controlling the size of the stamper protruding structures used in nanoimprinting. The depressed portions (minute holes) in the relief structure formed by nanoimprinting are non-penetrating holes, but can be made penetrating holes by removing the bottom portions using ion etching.

As a method of manufacturing a porous polymer layer 10' using nanoimprinting, for example a thermoplastic resin such as polymethyl methacrylate or similar is applied to a substrate, after which heating is performed at a temperature higher than the glass transition point of the thermoplastic resin to soften the thermoplastic resin, and then a stamper is pressed to transfer the relief pattern of the stamper. By then cooling the substrate, a porous polymer layer 10' having a prescribed minute hole structure can be obtained on the substrate. The stamper material is generally silicon, quartz, silicon carbide, tantalum, or similar; for use in this invention, silicon, which can be micro-machined, is particularly appropriate. In order to improve the release properties of the stamper and the polymer layer, a fluoride polymer and surfactant are generally applied to the stamper surface. As the material of the porous polymer layer 10', an ultraviolet ray hardening resin can be used; after pressing the stamper, photohardening can be performed, to eliminate the processes of heating and cooling the substrate. As polymers used in this method, polymethyl methacrylate, polystyrene, polycarbonate, and other thermoplastic resins, 1,6-hexane diol diacrylate, bis hydroxy ethyl-bis-phenol A-dimethylacrylate, and similar may be used; however, materials are not limited to these.

By means of this method, if within the range in which the stamper machining precision is obtained, the relief pattern can be accurately transferred. Manufacturing costs are somewhat higher than for resin self-organization due to the need to manufacture a stamper, but are very inexpensive compared with machining of individual elements by electron beam lithography or other methods.

The size of the layered magnetic film in this invention, that is, the distance between the insulating layers 30 on the right and left in Fig. 1, Fig. 2, Fig. 5 and Fig. 6, is not limited to a size at which domain walls do not exist (approximately 150 nm), as in the prior art shown in Fig. 3. This is because the sizes of individual elements are effectively determined by the sizes of the minute holes in the porous layer. Hence there is no need to reduce the distance between the insulating layers 30 to conform with magnetic domains. Even if domain walls were to exist in the layered magnetic film of some portions equivalent to minute holes, there would be only a very small number of such portions relative to the entirety of the integrated element, which would not have a large effect on the performance of the integrated element as a whole.

Hence expensive equipment is not necessary for element patterning, and for example the insulating layer 24 in Fig. 1, Fig. 5 and Fig. 6, or the portion above the nonmagnetic layer 51, may be manufactured to dimensions of approximately several micrometers without adverse results, and inexpensive photolithography equipment can be used.

In this way, by electrical connections to a magnetic multilayer film comprising a TMR layer or a GMR layer via minute holes of a porous layer, numerous spin valve elements can be integrated, and a large-output microwave oscillation element can be obtained.

### Practical Example 1

Using the structure of the first embodiment, first a TMR layer was fabricated by the following procedure. On a silicon substrate 5, sputtering was employed to layer in order, as in the first embodiment, the various layers using Au (5 nm)/Ta (5 nm) as the electrode layer 21; Ni₈₀Fe₂₀ (5 nm)/IrMn (8 nm) as the antiferromagnetic layer 22; Co₇₀Fe₃₀ (2 nm)/Ru (0.8 nm)/Co₄₀Fe₄₀B₂₀ (6 nm) as the ferromagnetic layer 23; MgO (0.8 nm) as the insulating layer 24; Co₄₀Fe₄₀B₂₀ (2 nm)/Ta (5 nm)/Ru (5 nm) as the ferromagnetic layer 25; Cu (2 nm)/Pd (3.5 nm) as the capping layer 26; and Au (2 nm) as the electrode layer 27. Then, annealing was performed at 350°C in a magnetic field of approximately 4 kOe. Notation in which a plurality of materials are delimited by a slash (/) indicates a layered member in which layers of the materials are layered in that order. Inside the parentheses are indicated the film thickness of each layer.

In addition, after an Al film (150 nm) was formed by sputtering and heat treatment was performed at 400°C in vacuum, electrochemical polishing was performed in an H₃PO₄, H₂SO₄ aqueous solution to flatten the surface. Anodic oxidation was performed using oxalic acid as the electrolyte, at a constant voltage of approximately 50 V. By this means a porous alumina layer 10 was obtained, having minute holes of diameter approximately 30 nm arranged regularly at intervals of approximately 140 nm. Then, immersion for several minutes in an H₃PO₄ aqueous solution was performed to cause penetration of the minute holes. By this means, the diameters of the minute holes were expanded to approximately 32 nm. Then the interiors of the minute holes 12 of the porous alumina layer 10 were filled with Cu by electroplating or another method to form the electrodes 11.

Starting from the substrate fabricated by the above procedure, after negative resist application and exposure treatment using ordinary visible-light photolithography, ion milling was performed to expose a region 3 µm in diameter on the insulating layer 24, after which CVD was used to form an insulating layer 30 by covering with SiO₂; after lift-off, sputtering was performed to form Al wiring lines 31, to obtain a sample of Practical Example 1. Approximately 340 minute holes existed in this element.

### Practical Example 2

Using the structure of the second embodiment, first a GMR layer was fabricated by the following procedure. That is, on a silicon substrate 5, sputtering was employed to layer, in order, Cu (25 nm) as the electrode layer 21; Co₇₀Fe₃₀ (20 nm) as the ferromagnetic layer 23; Cu (6 nm) as the nonmagnetic layer 51; NiFe (4.5 nm) as the ferromagnetic layer 25; Cu (2 nm)/Pd (3.5 nm) as the capping layer 26; and Au (2 nm) as the electrode layer 27. Then, annealing was performed at 250°C in a magnetic field of approximately 4 kOe. Thereafter, a method similar to that of Practical Example 1 was used to form a porous alumina layer, and after forming an electrode 11, wiring was performed in a region 3 µm in diameter to obtain a sample of Practical Example 2.

### Practical Example 3

Using the structure of the third embodiment, first Cr (10 nm)/Au (50 nm) was layered by sputtering on a silicon substrate 5 as the electrode layer 11, after which a method similar to that of Practical Example 1 was used to form a porous alumina layer, and the interiors of the minute holes 12 were filled with Cu as the electrodes 110 by electroplating. After flattening by chemical polishing, sputtering was used to layer, in order, Cu (2 nm) as the capping layer 26, NiFe (4.5 nm) as the ferromagnetic layer 25, a Cu layer (6 nm) as the nonmagnetic layer 51, Co₇₀Fe₃₀ (20 nm) as the ferromagnetic layer 23, and Cu (25 nm)/Pd (3.5 nm) as the electrode layer 21; then a method similar to that of Practical Example 1 was used to perform wiring in a region 3 µm in diameter, to obtain a sample of Practical Example 3. In Practical Example 3, the antiferromagnetic layer 22 shown in Fig. 6 was not used.

A 1 T DC magnetic field was applied to the substrates of samples of the Practical Examples 1 through 3 in the direction parallel to the magnetic field of the fixed layer, and by passing a DC current in the direction such that electrons flowed from the free layer to the fixed layer, microwave oscillation was obtained. The measurement conditions and measurement results appear in Table 1.

**Table 1**

| | Voltage (V) | Current (A) | Total output (W) | Output/element (W) | Frequency (GHz) |
|---|---|---|---|---|---|
| Practical Example 1 | 1.00 | 2.4E-02 | 4.1E-04 | 1.2E-06 | 21.2 |
| Practical Example 2 | 0.009 | 2.4E-02 | 2.6E-09 | 1.5E-11 | 14.2 |
| Practical Example 3 | 0.009 | 2.4E-02 | 2.1E-09 | 2.1E-11 | 25.4 |

As shown in Table 1, by means of this invention, in Practical Example 1 using TMR 0.41 mW is obtained, and in Practical Examples 2 and 3 using GMR 2.6 nW and 2.1 nW respectively are obtained. These are marked improvements compared with the outputs of conventional single elements (when using TMR, 0.16 µW, and when using GMR, approximately 10 pW). Worth noting is that, as the average output of the elements in each of the minute holes in this invention, 1.2 µW, 15 pW, and 21 pW were obtained for Practical Examples 1, 2 and 3 respectively, so that a marked improvement was obtained for single elements. The reason for this is not yet clear, but is surmised to arise from the above-described phase locking phenomenon observed when two elements are formed adjacently.

### Practical Example 4

Using the structure of the fourth embodiment, first a TMR layer was fabricated by the following procedure. That is, on a silicon substrate 5, sputtering was employed to layer, in order, Au (5 nm)/Ta (5 nm) as the electrode layer 21; Ni₈₀Fe₂₀ (5 nm)/IrMn (8 nm) as the antiferromagnetic layer 22; Co₇₀Fe₃₀ (2 nm), Ru (0.8 nm)/Co₄₀Fe₄₀B₂₀ (6 nm) as the ferromagnetic layer 23; MgO (0.8 nm) as the insulating layer 24; Co₄₀Fe₄₀B₂₀ (2 nm), Ta (5 nm)/Ru (5 nm) as the ferromagnetic layer 25; Cu (2 nm)/Pd (3.5 nm) as the capping layer 26; and Cu (30 nm) as the electrode layer 27. Then, annealing was performed at 350°C in a magnetic field of approximately 4 kOe.

Onto this, after treatment with an OTS (octadecyltrichlorosilane) self-organizing film, a polystyrene-methyl methacrylate (PS-PMMA) copolymer thin film was applied by spin coating. That is, a toluene solution (solid component concentration 2 weight percent) of a polystyrene-methyl methacrylate copolymer (manufactured by Polymer Science Inc., PS:PMMA = 70:30) was applied at a spin coating revolution rate of 2400 rpm, to obtain a thin film of film thickness 40 nm. Further, by performing annealing in vacuum for three hours at 170°C, phase separation of the polystyrene (PS) and polymethyl methacrylate (PMMA) was induced. Then, after irradiating with ultraviolet light to degrade the polymethyl methacrylate (PMMA), washing with glacial acetic acid and water was performed in selective removal, so that a porous structure with minute holes arranged regularly in a honeycomb shape was obtained. The minute holes had a cylindrical shape, perpendicular to the substrate, with a diameter of approximately 20 nm and pitch of approximately 40 nm. Then, electroplating or another method was used to fill the interiors of the minute holes 12 of the porous polymer layer 10 with Cu, to form electrodes 11.

Starting from the substrate fabricated by the above procedure, after negative resist application and exposure treatment using ordinary visible-light photolithography, ion milling was performed to expose a region 2.5 µm in diameter on the insulating layer 24, after which CVD was used to form an insulating layer 30 by covering with SiO₂; after lift-off, sputtering was performed to form Al wiring lines 31, to obtain a sample of Practical Example 4. Approximately 2930 minute holes existed in this element.

### Practical Example 5

Using the structure of the fifth embodiment, first a GMR layer was fabricated by the following procedure. That is, on a silicon substrate 5, sputtering was employed to layer, in order, Cu (25 nm) as the electrode layer 21; Co₇₀Fe₃₀ (20 nm) as the ferromagnetic layer 23; Cu (6 nm) as the nonmagnetic layer 51; NiFe (4.5 nm) as the ferromagnetic layer 25; Cu (2 nm)/Pd (3.5 nm) as the capping layer 26; and Cu (30 nm) as the electrode layer 27. Then, annealing was performed at 250°C in a magnetic field of approximately 4 kOe. Thereafter, using a method similar to that of Practical Example 4, a porous polymer layer was formed, and after forming electrodes 11, wiring was formed in a region 2.5 µm in diameter, to obtain a sample of Practical Example 5.

### Practical Example 6

Using the structure of the fourth embodiment, first a TMR layer was fabricated, by a procedure similar to that of Practical Example 4, except for the fact that the thickness of the MgO of the insulating layer 24 was 1.0 nm. Then, a toluene solution of polymethyl methacrylate (solid component concentration 3 weight percent) was applied onto the TMR layer by spin coating and dried, to obtain a polymethyl methacrylate thin film (thickness 70 nm). Further, this was heated to approximately 120°, and by pressing a silicon stamper thereagainst, a pattern of minute holes of diameter 30 nm and pitch 100 nm was transferred; and by performing ion etching the bottom portions were removed to obtain penetrating holes. Then, a method similar to that of Practical Example 4 was used to form electrodes 11, and wiring was formed in a region 6 µm in diameter to obtain a sample of Practical Example 6. Approximately 2700 minute holes existed in this element region.

### Practical Example 7

Using the structure of the sixth embodiment, in place of a porous alumina layer, a porous polymer layer was fabricated; otherwise, a procedure similar to that of Practical Example 3 was used, first layering an electrode layer 11 on a silicon substrate 5, then forming a porous polymer layer by a method similar to that of Practical Example 4, and using electroplating to fill the interiors of the minute holes 12 with Cu as the electrodes 110. Below, similarly to the case of Practical Example 4, by using oxygen plasma treatment to remove the remaining polymer, a minute Cu columnar structure was formed, and by using a CVD method to perform SiO₂ coverage, and then polishing the surface, the Cu forming fine columnar structures was exposed, so that an electrode 13 having heat resistance was formed. Then, sputtering was used to layer, in order, Cu (2 nm) as the capping layer 26; NiFe (4.5 nm) as the ferromagnetic layer 25; a Cu layer (6 nm) as the nonmagnetic layer 51; Co₇₀Fe₃₀ (20 nm) as the ferromagnetic layer 23; and Cu (25 nm)/Pd (3.5 nm) as the electrode layer 21. A method similar to that of Practical Example 4 was used to perform wiring of a region of diameter 8 µm, to obtain a sample of Practical Example 7.

A 1 T DC magnetic field was applied to the substrates of the samples of Practical Examples 4 through 7 in the direction parallel to the magnetic field of the fixed layer, and by passing a DC current in the direction such that electrons flowed from the free layer to the fixed layer, microwave oscillation was obtained. Measurement conditions and measurement results appear in Table 2.

**Table 2**

| | Voltage (V) | Current (A) | Total output (W) | Output/element (W) | Frequency (GHz) |
|---|---|---|---|---|---|
| Practical Example 4 | 5.0E+00 | 9.2E-02 | 6.7E-03 | 2.3E-06 | 21.2 |
| Practical Example 5 | 9.0E-03 | 9.2E-02 | 5.3E-08 | 1.8E-11 | 14.2 |
| Practical Example 6 | 1.0E+01 | 1.9E-01 | 4.1E-03 | 1.5E-06 | 25.4 |
| Practical Example 7 | 9.0E-03 | 9.2E-02 | 7.0E-08 | 2.4E-11 | 16.7 |

As shown in Table 2, by means of this invention, outputs of 6.7 mW and 4.1 mW were obtained for Practical Examples 4 and 6 respectively using TMR, and outputs of 53 nW and 70 nW were obtained for Practical Examples 5 and 7 respectively using GMR. These are marked improvements compared with the outputs from conventional single elements (0.16 µW when using TMR, approximately 10 pW when using GMR). Worth noting is that the average outputs of each of the minute-hole elements in this invention were 2.3 µW, 18 pW, 1.5 µW, 24 pW for Practical Examples 4 through 7 respectively, so that improvements were obtained for single elements as well. The reason for this is not yet clear, but it is surmised to arise from the above-described phase locking phenomenon observed when two elements are formed adjacently.

In the above, embodiments of the invention have been described; but the invention is not limited to the above-described embodiments, and various modifications, alterations and combinations are possible, based on the technical concept of the invention.

## Claims

1. A magnetic element, comprising:
a magnetic multilayer film, including at least three layers, an insulating layer and first and second ferromagnetic layers sandwiching the insulating layer; and
a porous layer, placed in contact with the first ferromagnetic layer or near the first ferromagnetic layer with another layer intervening, and having a plurality of minute holes, wherein
an electrical connection is made with the first ferromagnetic layer of the magnetic multilayer film through the minute holes of the porous layer, and another electrical connection is made with the second ferromagnetic layer.

2. A magnetic element, comprising:
a magnetic multilayer film, including at least three layers, a nonmagnetic layer and first and second ferromagnetic layers sandwiching the nonmagnetic layer; and
a porous layer, placed in contact with the first ferromagnetic layer or near the first ferromagnetic layer with another layer intervening, and having a plurality of minute holes, wherein
an electrical connection is made with the first ferromagnetic layer of the magnetic multilayer film through the minute holes of the porous layer, and another electrical connection is made with the second ferromagnetic layer.

3. The magnetic element according to Claim 1 or Claim 2, wherein the porous layer is a porous alumina layer manufactured by an anodic oxidation method.

4. The magnetic element according to Claim 1 or Claim 2, wherein, in the porous layer, the distance between the centers of adjacent minute holes is 1000 nm or less.

5. The magnetic element according to Claim 3, wherein, in the porous layer, the distance between the centers of adjacent minute holes is 1000 nm or less.

6. The magnetic element according to Claim 1 or Claim 2, wherein the equivalent diameter of the minute holes is 100 nm or less.

7. The magnetic element according to Claim 3, wherein the equivalent diameter of the minute holes is 100 nm or less.

8. The magnetic element according to Claim 1 or Claim 2, wherein the porous layer is formed by a nanoimprinting method.

9. The magnetic element according to Claim 1 or Claim 2, wherein the porous layer is formed utilizing resin self-organization.
